# EUROPÄISCHE PATENTSCHRIFT

(11) **EP 1 291 720 B1**
(45) Veröffentlichungstag und Bekanntmachung des Hinweises auf die Patenterteilung: **21.06.2006**
(21) Anmeldenummer: 02018978.3
(22) Anmeldetag: 27.08.2002
(51) Int. Cl.: G03F 7/20, G02B 15/14

(54) **Zoom-System für eine Beleuchtungseinrichtung**
Zoom system for illumination apparatus
Système à zoom pour dispositif d'illumination

(30) Priorität: 05.09.2001 DE 10144243
(43) Veröffentlichungstag der Anmeldung: 12.03.2003
(73) Patentinhaber: Carl Zeiss SMT AG, 73446 Oberkochen (DE)
(72) Erfinder: Koehler, Jess, 73447 Oberkochen (DE); Wangler, Johannes, 89551 Koenigsbronn (DE)
(74) Vertreter: Patentanwälte Ruff, Wilhelm, Beier, Dauster & Partner

(56) Entgegenhaltungen:
- EP-A- 1 211 561
- EP-A- 1 235 113
- US-B1- 6 249 335

## Beschreibung

Die Erfindung betrifft ein Zoom-System für eine Beleuchtungseinrichtung, insbesondere eine Beleuchtungseinrichtung einer mikrolithographischen Projektionsbelichtungsanlage.

Beleuchtungseinrichtungen in mikrolithographischen Projektionsbelichtungsanlagen haben die Aufgabe, ein Retikel, welches in der Objektebene eines nachfolgenden Projektionsobjektives angeordnet ist, gleichmäßig in einer genau an die optischen Eigenschaften des Projektionsobjektivs angepassten Weise zu beleuchten. Die Beleuchtung soll telezentrisch sein, so dass die gerichteten Lichtschwerpunkte aller Punkte der Retikelebene möglichst exakt in der Eintrittspupille des Projektionsobjektives zentriert sind. Zudem ist es erwünscht, eine partiell kohärente Beleuchtung bereitzustellen, bei der der Füllgrad der Pupille variabel einstellbar ist. Für die Variation des Kohärenzgrades werden in der Regel Zoom-Systeme eingesetzt. Um bei der lithographischen Mikrostrukturierung eine weitgehende Annäherung an die Auflösungsgrenzen der optischen Projektion zu ermöglich, wird vielfach auch die Beleuchtung entsprechend der Strukturen der einzelnen Vorlagen optimiert, indem diverse Beleuchtungsmodi, beispielsweise annulare Beleuchtung oder Quadrupol-Beleuchtung erzeugt werden. Einrichtung hierfür, beispielsweise kegelförmige oder pyramidenförmige Axicons, können in Zoom-Systeme integriert sein. Schließlich besteht die Forderung nach einem hohen Wirkungsgrad, um die Lichtleistung der Lichtquellen mit geringstmöglichen Lichtverlusten für die Herstellung mikrostrukturierter Bauteile nutzen zu können.

Beleuchtungseinrichtungen, welche diese Anforderung gut erfüllen, sind beispielsweise in der EP 0 747 772 oder der DE 44 21 053 bzw. EP 0 687 956 offenbart. Bei der Beleuchtungseinrichtung der EP 0 747 772 hat das Zoom-System eine Vielzahl von Linsen, die entlang einer optischen Achse angeordnet sind und eine Objektebene sowie eine Bildebene definieren, welche eine Fourier-transformierte Ebene zur Objektebene ist. Zwei Linsen sind verschiebbare Linsen, die bei der Einstellung von Zoomstellungen des Zoom-Systems zur Variation der Größe einer in der Bildebene ausgeleuchteten Fläche entlang der optischen Achse verschiebbar ist. In der Objektebene und in der Austrittspupille des Zoom-Objektivs sind jeweils diffraktive optische Rasterelemente mit zweidimensionaler Rasterstruktur angeordnet. Die Anordnung dient zur angepassten Erhöhung des Lichtleitwertes, wobei das in der Objektebene angeordnete Rasterelemente zusammen mit dem Zoom-Objektiv einen kleineren Teil des Lichtleitwertes einfügt und das in der Bildebene angeordnete Rasterelement den Hauptanteil des Lichtleitwertes erzeugt und die Beleuchtung an die Feldgröße, beispielsweise die rechteckige Eintrittfläche eines nachfolgenden, stabförmigen Lichtintegrators adaptiert. Das Zoomsystem hat einen dreifachen Dehnungsbereich, wobei partiell kohärente Beleuchtung mit Kohärenzgraden zwischen 0,3 und 0,9 eingestellt werden kann.

Das Patent US 6,249,335 B1 beschreibt verschiedene Belichtungsverfahren und hierfür geeignete Projektionsbelichtungsapparate. Im Zusammenhang mit der Beschreibung verschiedener Beleuchtungsmodi wird erläutert, dass es dort, wo zwischen schräger Beleuchtung und senkrechter Beleuchtung umgeschaltet werden soll, wünschenswert sein kann, dass der durch den σ-wert angebbare Kohärenzgrad innerhalb eines Bereiches 0,1 < σ < 0,7 variabel gemacht wird. Es wird erwähnt, dass für diesen Zweck auch ein Zoom-System eingesetzt werden kann. Details zum Aufbau und zur Funktion eines geeigneten Zoom-Systems sind nicht angegeben.

Aus der US 5,379,090 ist ein Zoom-System für eine Beleuchtungseinrichtung einer mikrolithographischen Projektionsanlage bekannt, das einen vierfachen Dehnungsbereich hat und die Einstellung von Kohärenzgraden zwischen 0,1 und 0,4 erlaubt.

Aus der US 5,237,367 ist die Verwendung eines Zoom-Systems in der Beleuchtungseinrichtung eines Wafer-Steppers zur verlustfreien Einstellung des Kohärenzgrades bekannt.

Aus der US 5,245,384 ist ein afokales Zoom-System für die Beleuchtung bei Wafer-Steppern bekannt, mit dem ebenfalls der Kohärenzgrad verlustarm angepasst werden kann.

Aus der EP 1 109 067 (entsprechend US 2001 001247 A1) ist ein Beleuchtungssystem für eine mikrolithographische Projektionsanlage bekannt, das ohne die Verwendung eines Zoom-Systems die Einstellung verschiedener Beleuchtungssettings erlaubt. Die Intensitätsverteilung des Lichtstrahls in einer Pupillenebene des Beleuchtungssystems wird durch eine Abfolge optischer Elemente bestimmt, von denen mindestens eines mit Hilfe einer Auswechseleinrichtung gegen ein anderes optisches Element austauschbar ist. Diese austauschbaren optischen Elemente können durch diffraktive optische Elemente (DOE), Mikrolinsen-Arrays oder holographische optische Elemente gebildet sein, die jeweils unterschiedliche Beleuchtungssetting definieren. Die für den Elementaustausch erforderlichen Einrichtungen müssen schnell und hochpräzise arbeiten, so dass erheblicher mechanischer und Steuerungsaufwand zur Verwirklichung dieses Konzepts erforderlich ist.

Bei zahlreichen Anwendungsfällen, insbesondere im Bereich der mikrolithographischen Produktion von Halbleiterbauelementen und anderen feinstrukturierten Bauteilen, ist es erwünscht, zwischen verschiedenen Beleuchtungssettings umschalten zu können, ohne dass optische Elemente ausgetauscht werden müssen. Außerdem ist es häufig erwünscht, sehr unterschiedliche konventionelle Beleuchtungssettings einstellen zu können. Eine besonders bei kurzen Lichtwellenlängen (beispielsweise 193nm, 157nm oder darunter) wichtiger werdende Randbedingung ist die Forderung, die Anzahl der optischen Flächen des Systems auf ein Minimum zu reduzieren, um Transmissionsverluste in Grenzen zu halten. Besonders bei Beleuchtungssystem, in denen hinter dem Zoom-System nur winkelerhaltende optische Elemente, z.B. stabförmige Lichtintegratoren, angeordnet sind, ist außerdem eine ausgangsseitige (bildseitige) Telezentrie des Zoom-Systems vorteilhaft, um eine Anpassung an die nachfolgenden optischen Systeme zu ermöglichen.

Der Erfindung liegt die Aufgabe zugrunde, ein Zoom-System für eine Beleuchtungseinrichtung zu schaffen, welches ohne Austausch optischer Komponenten eine große Variationsbreite einstellbarer Kohärenzgrade ermöglicht. Insbesondere soll sich das Zoom-System außerdem durch ausgangsseitige Telezentrie, gute Gleichmäßigkeit der ausgangsseitigen Energieverteilung mit geringer Kantenbreite und hohe Transmission auszeichnen.

Diese Aufgabe wird gelöst durch ein Zoom-System mit den Merkmalen von Anspruch 1. Vorteilhafte Weiterbildungen sind in den abhängigen Ansprüchen angegeben. Der Wortlaut sämtlicher Ansprüche wird durch Bezugnahme zum Inhalt der Beschreibung gemacht.

Ein erfindungsgemäßes Zoom-System hat eine Vielzahl von Linsen, die entlang einer optischen Achse angeordnet sind und eine Objektebene sowie eine Bildebene definieren. Mindestens eine der Linsen ist eine verschiebbare Linse, die zur Variation der Größe einer in der Bildebene ausgeleuchteten Fläche entlang der optischen Achse verschiebbar ist. Ein Verhältnis D zwischen einer maximalen Größe und einer minimalen Größe der in der Bildebene ausgeleuchteten Fläche beträgt mehr als vier. Dieses Verhältnis D wird im folgenden auch als Dehnung oder Dehnungsfaktor bezeichnet und kann beispielsweise bei einer im wesentlichen kreisförmigen, ausgeleuchteten Fläche als Verhältnis zwischen maximalem Radius und entsprechendem minimalem Radius dieser Fläche berechnet werden. Bei besonders vorteilhaften Ausführungsformen sind sogar Dehnungsfaktoren von fünf oder mehr möglich. Vorzugsweise ist das Zoom-System als Brennweiten-Zoom ausgebildet, bei dem die Bildebene eine Fourier-transformierte Ebene zur Objektebene ist. Zwischen Objektebene und Bildebene ist bei bevorzugten Ausführungsformen keine Zwischenbildebene gebildet.

Die optische Funktion einer einzelnen Linse kann grundsätzlich auch durch eine Kombination mehrerer Linsen, d.h. eine Linsengruppe, oder durch eine zusätzliche asphärische Fläche erzielt werden. Der Begriff "Linse" umfasst in dieser Anmeldung daher allgemein auch eine "Linsengruppe".

Erfindungsgemäße Zoom-Systeme ermöglichen allein durch ihre Konstruktion eine große Variationsbreite für den Kohärenzgrad σ des vom Beleuchtungssystem abgegebenes Lichtes, wobei durch Verschiebung von Linsen des Zoom-Systems zwischen nahezu kohärenter Strahlung (kleiner σ-Wert) zu weitgehend inkohärenter Strahlung (großer σ-Wert) vorzugsweise stufenlos umgestellt werden kann. Dabei kann die Lage des erzielbaren σ-Bereiches durch den Öffnungswinkel der in das Zoom-System einfallenden Strahlung beeinflusst werden. Dieser Öffnungswinkel kann beispielsweise durch dem Zoom-System vorgeschaltete optische Mittel zur Erzeugung einer gewünschten Winkelverteilung aus einfallendem Parallellicht, beispielsweise durch ein diffraktives optisches Rasterelement, eingestellt werden. Da das Zoom-System selbst einen großen Dehnungsbereich bzw. σ-Bereich abdeckt, kann bei den meisten Anwendungsfällen mit einer einzigen, eingangsseitigen Winkelverteilung für alle Beleuchtungssetting gearbeitet werden. Auf austauschbare Rasterelemente oder dergleichen kann daher verzichtet werden, was den Gesamtaufbau von Beleuchtungseinrichtungen vereinfacht.

Die erfindungsgemäß hohen Dehnungen werden bei bevorzugten Ausführungsformen dadurch gefördert, dass ein maximaler Verschiebeweg mindestens einer der verschiebbaren Linsen mehr als ca. 35% bzw. etwa ein Drittel der Baulänge des Zoom-Systems beträgt. Als Baulänge wird in dieser Anmeldung der axiale Abstand zwischen Objektebene und Bildebene bezeichnet. Diese Baulänge ist bei bevorzugten Ausführungsformen fest und unabhängig von der eingestellten Zoom-Stellung, was den Einbau derartiger Zoom-Systeme in räumlich definierte Einbauumgebungen, beispielsweise einer Beleuchtungseinrichtung eines Wafer-Steppers, erleichtert. Vorzugsweise ist sogar mindestens eine der verschiebbaren Linsen um mindestens ca. 45% der Baulänge verschiebbar. Hier wird die Erkenntnis genutzt, dass eine große Dehnung der Bildfeldgröße durch große Verschiebewege erzielbar ist.

Um trotz großer Verschiebewege die Baulänge des Gesamtsystems kompakt zu halten und insbesondere im Vergleich zu früheren Systemen weitgehend unverändert zu erhalten, sind bei bevorzugten Ausführungsformen feste Linsen nahe bei der Objektebene und, mit Einschränkungen, auch nahe der Bildebene angeordnet. Vorzugsweise kann ein Abstand zwischen der Objektebene und dem der Objektebene nächsten optischen Element des Zoom-Systems weniger als 15%, insbesondere sogar weniger als 5% der Baulänge des Zoom-Systems entsprechen. Dies macht es auch möglich, dass ein Verschiebebereich mindestens einer verschiebbaren Linse in einem Abstand von der Objektebene endet, der weniger als 15%, insbesondere weniger als 5% der Baulänge des Zoom-Objektivs beträgt. Am bildseitigen Ende des Zoom-Systems kann für mindestens eine verschiebbare Linse der Verschiebeweg in einem Abstand von der Bildebene enden, der weniger als 50%, insbesondere weniger als 35% der Baulänge des Zoom-Objektives beträgt. Damit kann ein Zoom-System mit optischen Mitteln geschaffen werden, die abhängig von der Zoom-Stellung, d.h. von den axialen Stellungen verschiebbare Linsen sind und sowohl zur Winkelkorrektion als auch zur Ortskorrektion verwendet werden können.

Um bei möglichst geringer Anzahl von Linsen große Verschiebewege zu ermöglichen, ist es bevorzugt, die Anzahl der feststehenden Linsen zu minimieren. Bei bevorzugten Ausführungsformen ist die Anzahl verschiebbarer Linsen gleich oder größer als die Anzahl der feststehenden Linsen. Beispielsweise können drei feststehende und vier verschiebbare Linsen vorgesehen sein. Es hat sich als günstig herausgestellt, wenn die verschiebbaren Linsen mindestens eine Linsengruppe mit zwei oder mehr gemeinsam verschiebbaren Linsen umfasst. Vorzugsweise besteht jede verschiebbare Linsengruppe aus wenigstens zwei Einzellinsen. Dadurch wird die von der Zoomstellung abhängige Korrektion der Lichtstrahlverläufe einfacher und es treten geringere Inzidenzwinkel auf. Bevorzugt sind maximal zwei verschiebbare Linsen oder Linsengruppen, um die mechanische Konstruktion der für die Linsenverschiebung erforderlichen Bauteile einfach halten zu können. Um trotz geringer Anzahl verschiebbare Linsen oder Linsengruppen einen großen Dehnungsbereich zu erhalten, kann eine erste verschiebbare Linse oder Linsengruppe und mindestens eine zweite verschiebbare Linse oder Linsengruppe vorgesehen sein, die beim Wechsel zwischen verschiedenen Zoom-Stellungen auf unterschiedlichen Verschiebekurven verschiebbar sind. Dies kann beispielsweise durch unabhängige Antriebe oder durch eine geeignete nicht-lineare Kopplung erreicht werden.

Bei allen Ausführungsformen der beanspruchen Erfindung ist vorgesehen, dass zwischen der Objektebene und der Bildebene mindestens eine optische Komponente mit mindestens einer asphärischen Fläche angeordnet ist. Besonders vorteilhaft ist, wenn mindestens eine asphärische Fläche an einem verschiebbaren Element angeordnet ist, wodurch die Korrektionswirkung der Asphäre gegebenenfalls stark variiert werden kann. Durch den Einsatz von Asphären kann gegebenenfalls die erforderliche Anzahl von Systemflächen minimiert werden. Eine geringe Anzahl von Systemflächen ist besonders bei kurzen Arbeitswellenlängen, wie beispielsweise 193nm, 157nm oder 126nm, günstig, da die Transmissionsverluste in den verfügbaren optischen Materialien, beispielsweise Kalziumfluorid, mit sinkender Wellenlänge aufgrund zunehmender Absorption zunehmen und weil auch die Wirksamkeit optischer Beschichtungen mit abnehmender Wellenlänge abnimmt, während gleichzeitig Degradationseffekte bei kürzeren Wellenlängen zunehmen. Bevorzugte Systeme haben nicht mehr als acht Linsen, vorzugsweise nur sieben oder weniger Linsen. Die Anordnung mindestens einer asphärischen Fläche im Zoom-System bringt auch Vorteile im Hinblick auf die Performance des Systems, indem durch die Formgebung der Asphäre z.B. Einfluss auf die Gleichmäßigkeit der Intensität im ausgeleuchteten Bereich (top head), die Kantensteilheit am Rande des ausgeleuchteten Bereichs und auf die bildseitige Telezentrie des Zoom-Systems genommen werden kann.

Die vorstehenden und weiteren Merkmale gehen außer aus den Ansprüchen auch aus der Beschreibung und den Zeichnungen hervor, wobei die einzelnen Merkmale jeweils für sich alleine oder zu mehreren in Form von Unterkombinationen bei einer Ausführungsform der Erfindung und auf anderen Gebieten verwirklicht sein und vorteilhafte sowie für sich schutzfähige Ausführungen darstellen können. Es zeigen:
- Fig. 1: eine schematische Übersicht einer Ausführungsform einer Beleuchtungseinrichtung für ein Projektions-Mikrolithographiegerät mit einer Ausführungsform eines erfindungsgemäßen Zoom-Systems;
- Fig. 2: einen Linsenschnitt durch eine erste Ausführungsform eines erfindungsgemäßen Zoom-Systems in fünf Zoom-Stellungen, wobei das Zoom-System an einer verschiebbaren Linse eine asphärische Fläche hat; und
- Fig.3: ein Linsenschnitt durch eine zweite, nicht zum beanspruchten Erfindung gehärige Ausführungsform eines Zoom-Systems in fünf Zoom-Stellungen, wobei das Zoom-System keine asphärischen Flächen hat.

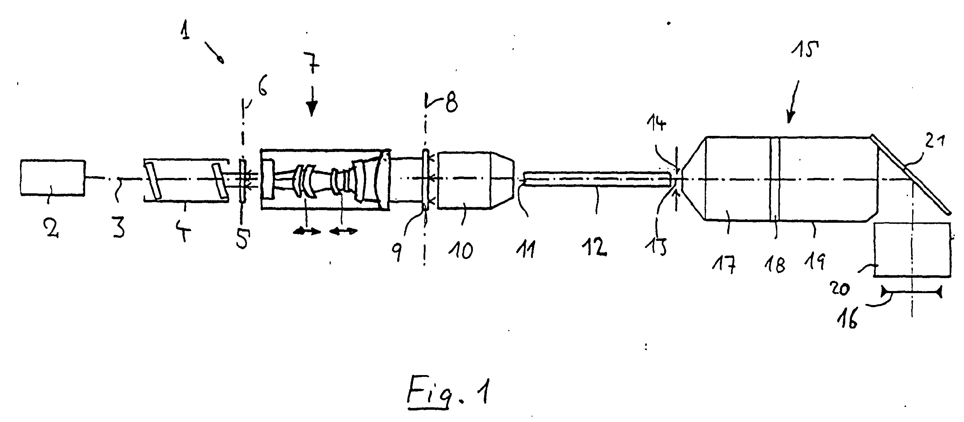

In Fig. 1 ist ein Beispiel einer Beleuchtungseinrichtung 1 einer mikrolithographischen Projektionsbelichtungsanlage gezeigt, die bei der Herstellung von Halbleiterbauelementen und anderen feinstrukturierten Bauteilen einsetzbar ist und zur Erzielungen von Auflösungen bis zu Bruchteilen von Mikrometern mit Licht aus dem tiefen Ultraviolettbereich arbeitet. Als Lichtquelle 2 dient ein F₂-Excimer-Laser mit einer Arbeitswellenlänge von ca. 157nm, dessen Lichtstrahl koaxial zur optischen Achse 3 des Beleuchtungssystems ausgerichtet ist. Andere UV-Lichtquellen, beispielsweise ArF-Excimer-Laser mit 193nm Arbeitswellenlänge, KrF-Excimer-Laser mit 248nm Arbeitswellenlänge oder Quecksilberdampflampen mit 368nm bzw. 436nm Arbeitswellenlänge sind ebenfalls möglich. Das Licht der Lichtquelle 2 tritt zunächst in einem Strahlaufweiter 4 ein, der beispielsweise als Spiegelanordnung gemäß der DE 41 24 311 ausgebildet sein kann und zur Kohärenzreduktion und Vergrößerung des Strahlquerschnitts auf z.B. y = 35 ± 10mm und x = 10 ± 5mm dient. Ein optional vorgesehener Verschluss ist bei der gezeigten Ausführungsform durch eine entsprechende Pulssteuerung des Lasers 2 ersetzt.

Ein erstes diffraktives, optisches Rasterelement 5 ist in der Objektebene 6 eines im Strahlengang dahin angeordneten Zoom-Objektivs 7 angeordnet, in dessen Bildebene 8 bzw. Austrittspupille ein zweites diffraktives optisches Rasterelement 9 angeordnet ist.

Eine dahinter angeordnete Einkoppeloptik 10 überträgt das Licht auf die Eintrittsfläche 11 eines aus Kalziumfluorid gefertigten, stabförmigen Lichtintegrators 12, der das durchtretende Licht durch mehrfache innere Reflexion mischt und homogenisiert. Unmittelbar an der Austrittsfläche 13 des Stabes 12 liegt eine Zwischenfeldebene, in der ein Reticle/Masking-System (REMA) 14 angeordnet ist, welches als verstellbare Feldblende dient. Das nachfolgende Objektiv 15 bildet die Zwischenfeldebene mit dem Maskierungssystem 14 auf Retikel 16 (Maske, Lithographievorlage) ab und enthält eine erste Linsengruppe 17, eine Pupillenzwischenebene 18, in die Filter oder Blenden eingebracht werden können, eine zweite und eine dritte Linsengruppe 19 bzw. 20 und dazwischen einen Umlenkspiegel 21, der es ermöglicht, die große Beleuchtungseinrichtung (ca. 3m Länge) horizontal einzubauen und das Retikel 16 waagrecht zu lagern.

Dieses Beleuchtungssystem bildet zusammen mit einem (nicht gezeigten) Projektionsobjektiv und einem verstellbaren Wafer-Halter, der das Retikel 16 in der Objektebene des Projektionsobjektivs hält, eine Projektionsbelichtungsanlage für die mikrolithographische Herstellung von elektronischen Bauteilen, aber auch von optisch diffraktiven Elementen und anderen mikrostrukturierten Teilen.

Bei einem Wafer-Stepper wird auf dem Retikel 16 die gesamte, einem Chip entsprechende strukturierte Fläche, im allgemeinen ein Rechteck mit einem beliebigen Aspektverhältnis von beispielsweise 1:1 bis 1:2, insbesondere 1:1,3, so gleichmäßig und randscharf wie möglich beleuchtet.

Bei einem Wafer-Scanner wird auf dem Reticel ein schmaler Streifen, typischerweise ein Rechteck mit einem Aspektverhältnis von 1:2 bis 1:8 beleuchtet, und durch Scannen das gesamte strukturierte Feld eines Chips seriell beleuchtet. Auch hier ist die Beleuchtung extrem gleichmäßig und, in Richtung senkrecht zur Scanrichtung, randscharf zu gestalten.

In manchen Fällen sind auch andere Formen der beleuchteten Fläche auf dem Retikel 16 möglich. Die Öffnung des Reticle-Masking-Systems 14 und der Querschnitt des Stabes 12 sind zweckmäßig der benötigten Form genau angepasst.

Die Ausführung der dem stabförmigen Lichtintegrator 12 vorgelagerten Teile, insbesondere der optischen Rasterelemente 5 und 9, ist so gewählt, dass die Stabeintrittsfläche 11 weitgehend homogen und mit höchstmöglichem Wirkungsgrad, das heißt ohne wesentliche Lichtverluste neben der Eintrittfläche, ausgeleuchtet wird. Hierzu wird der vom Strahlaufweiter 4 kommende, parallele Lichtstrahl mit rechteckigem Querschnitt und einer nicht rotationssymmetrischen Divergenz zunächst durch das erste diffraktive Rasterelement 5 unter Einführung von Lichtfeitwert bezüglich Divergenz und Form verändert. Insbesondere hat das erste Rasterelement 5 eine Vielzahl sechseckiger Zellen, die eine Winkelverteilung dieser Form erzeugen. Die numerische Apertur des ersten diffraktiven Rasterelements beträgt beispielsweise NA= 0,027, wodurch etwa 10% des gesamten einzuführenden Lichtleitwertes eingeführt werden. Das in der vorderen Brennebene der Zoomoptik 7 angeordnete erste optische Rasterelement 5 präpariert zusammen mit der Zoomoptik 7 eine variable, sekundäre Lichtquelle (erste Pupillenebene des Beleuchtungssystems) in der hinteren Brennebene bzw. Bildebene 8 des Zoom-Systems. Hier ist das zweite optische Rasterelement 9 angeordnet, das als refraktives optisches Element mit rechteckiger Abstrahlcharakteristik ausgebildet ist. Dieses Element erzeugt den Hauptanteil des Lichtleitwertes und adaptiert den Lichtleitwert über die Einkoppel-Optik 10 an die Feldgröße, das heißt an die Form der rechteckigen Eintrittsfläche 11 des Stabintegrators 12.

Der Aufbau des Beleuchtungssystems mit Ausnahme des Zoom-Objektivs 7 kann beispielsweise dem in der EP 0 747 772 beschriebenen Aufbau entsprechen.

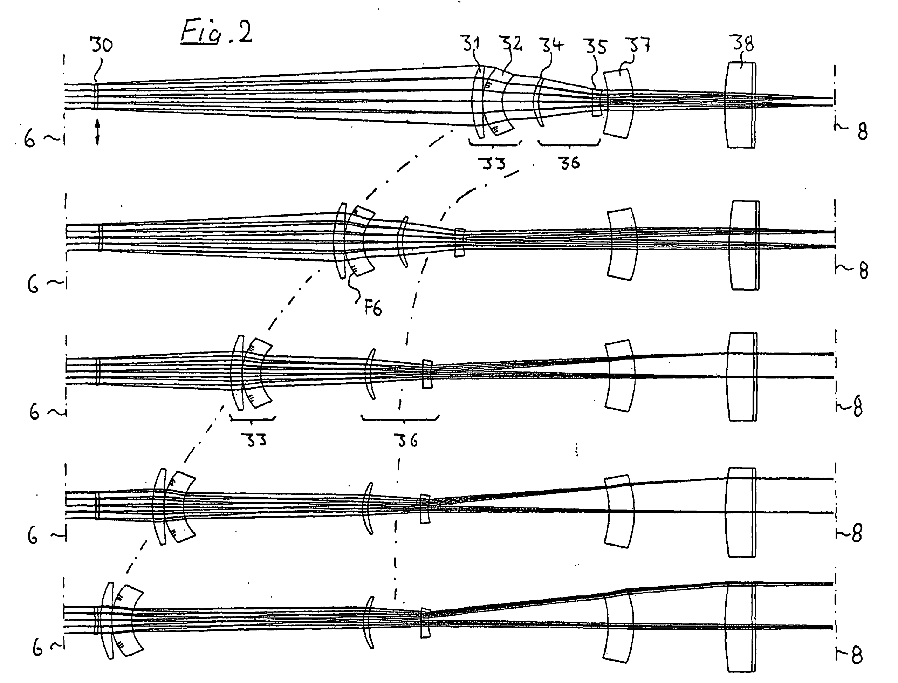

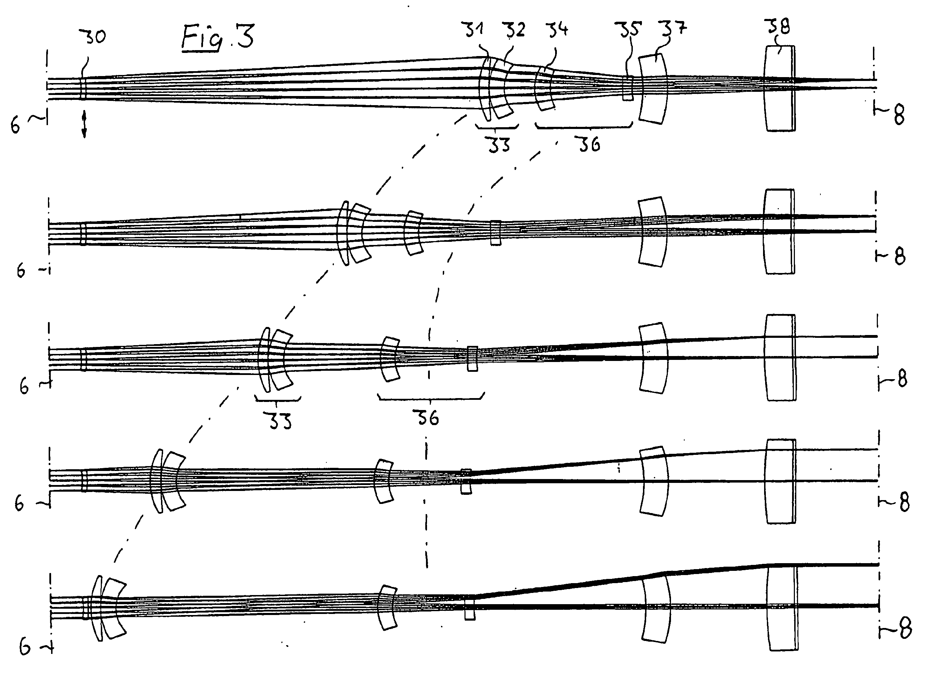

Im folgenden werden Aufbau und Wirkungsweise sowie Besonderheiten des Zoom-Systems 7 an Hand von zwei Ausführungsbeispielen näher erläutert, wobei Fig. 2 eine Ausführungsform mit einer asphärischen Fläche auf einer verschiebbaren Linse zeigt, während bei der nicht zur beanspruchten erfindung gehörenden Ausführungsform gemäß Fig. 3 alle Linsenflächen sphärisch sind. Aufgrund des ähnlichen Aufbaus der Ausführungsformen werden aus Gründen der Übersichtlichkeit einander entsprechende Elemente mit gleichen Bezugszeichen bezeichnet.

Die Zoom-Systeme beider Ausführungsformen sind als zwischenbildfreies Brennweiten-Zoom ausgebildet, bei dem die Objektebene 6 und die Bildebene 8 Fourier-transformierte Ebenen sind und zwischen diesen Ebenen keine Zwischenbildebene liegt.

Das Zoom-System 7 in Fig. 2 hat eine feste Baulänge (Abstand Objektebene - Bildebene) von ca. 1020mm. In einem kurzen Arbeitsabstand von ca. 40mm von der Feldebene 6 ist eine meniskusförmige erste Linse 30 mit einer von der Objektebene 6 weg gekrümmten Eintrittsfläche F2 und einer ebenso gekrümmten Austrittsfläche F3 angeordnet, wobei die Linse 30 negative Brechkraft aufweist und den eintretenden Lichtstrahl leicht aufweitet. Mit variablem Luftabstand folgt eine meniskusförmige zweite Linse 31 positiver Brechkraft mit zur Objektebene gekrümmter Eintrittsfläche F4 und in die gleiche Richtung schwächer gekrümmter Austrittsfläche F5. Mit einem festen Abstand von nur ca. 0,06mm folgt eine meniskusförmige dritte Linse 32 positiver Brechkraft mit zur Objektebene gekrümmter, asphärischer Eintrittsfläche F6 und ebenso gekrümmter, sphärischer Austrittsfläche F7. Die zweite Linse 31 und die dritte Linse 32 sind gemeinsam axial beweglich geführt und bilden eine erste bewegliche Linsengruppe 33. Mit variablem Luftabstand hinter der dritten Linse 32 folgt eine meniskusförmige vierte Linse 34 positiver Brechkraft mit objektwärts gekrümmter Eintrittsfläche F8 und ebenso gekrümmter Austrittsfläche F9. Dieser folgt mit festem Luftabstand eine fünfte Linse 35 mit negativer Brechkraft, nahezu ebener Eintrittsfläche F10 und konkaver Austrittsfläche F11. Die vierte Linse 34 und die fünfte Linse 35 sind gemeinsam axial beweglich geführt und bilden die zweite bewegliche Linsengruppe 36 des Zoom-Systems. In Lichtdurchtrittsrichtung folgt eine ortsfest montierte sechste Linse 37, die als Meniskuslinse mit negativer Brechkraft ausgebildet ist und eine zur Bildebene gekrümmte Eintrittsfläche F12 und eine ebenso gekrümmte Austrittsfläche F13 hat. Dieser folgt mit festem Luftabstand eine ebenfalls fest montierte siebte Linse 38 mit positiver Brechkraft, objektwärts gekrümmter Eintrittsfläche F14 und ebener Austrittsfläche F15. Diese steht in festem Abstand von ca. 120mm von der Bildebene 8.

Die Krümmungsradien r [mm] der Linsenflächen, die entsprechenden Dicken d [mm] sowie die halben maximalen Strahldurchmesser hmax [mm], welche an den Flächen F der Linsen auftreten und den optisch genutzten Radien entsprechen, sind in Tabelle 1 gezeigt. Tabelle 2 zeigt die asphärischen Konstanten der nicht sphärischen Fläche F6 des Zoom-Systems in der üblichen Notation. In Tabelle 3 sind für fünf verschiedene Zoomstellungen (Zoomstellung 1 bis Zoomstellung 5, in Fig. 2 von oben nach unten) die axialen Dimensionen der variablen Lufträume hinter den Linsenflächen F3, F7 und F11 [in mm] gezeigt. Sämtliche Linsen sind aus CaF₂ gefertigt, das bei der Betriebswellenlänge von 157,63nm einen nominalen Brechungsindex n=1,558 hat.

Im folgenden werden die Funktionen und weitere Besonderheiten des Zoom-Systems erläutert. Die Objektebene (Feldebene 6) wird durch eine Lichtverteilung mit rechteckigem Profil von ca. 20mm x 15mm beleuchtet. Durch das in der Objektebene angeordnete erste diffraktive Rasterelement 5 wird in der Objektebene eine Winkelverteilung erzeugt, die im Winkelraum eine sechseckige Form hat. Die mittlere numerische Apertur beträgt hier 25mrad. Dieses Licht durchstrahlt die Linsen des Zoom-Systems und erzeugt in der Bildebene 8 eine beleuchtete Fläche mit sechseckiger Form, wobei die Größe der beleuchteten Fläche durch Verschiebung der beiden verschiebbaren Linsengruppen 33 und 36 stufenlos einstellbar ist. Der Radius der zu dieser sechseckigen Form konstruierbaren Kreisfläche ist bei dieser Ausführungsform zwischen einem Minimalradius von 10mm (Zoomstellung 1, in Fig. 3 oben) und ein Maximalradius von ca. 50mm (Zoomstellung 5, in Fig. 3 unten) veränderbar, was einem Dehnungsfaktor bzw. einer Dehnung von 5,0 entspricht. Die minimal beleuchtete Fläche in der Bildebene ist kleiner und die maximal beleuchtete Fläche in der Bildebene größer als die Objektfeldgrö-ße. Für jede Zoomstellung variiert die Energiedichte in der Bildebene 8 (abgesehen vom Kantenbereich der Lichtverteilung) um maximal ca. 5%. Die Schwerstrahlrichtungen in der Bildebene weichen für alle Zoomstellungen um höchstens 1 mrad von der Richtung der optischen Achse 3 ab, so dass bildseitige Telezentrie durchgängig gegeben ist. Die Lichtbüschel in der Bildebene haben in jeder Zoomstellung eine Apertur, die kleiner als ca. 0,055 ist. Dadurch hat die genaue Lage der Bildebene, welche von der Zoomstellung abhängig ist, wenig Einfluß auf die Lichtverteilung in der realen festen Bildebene. Die genaue Winkelverteilung innerhalb eines solchen niedrig-aperturigen Büschel hat nur sehr geringen Einfluß auf die Performance des Bildes.

Es ist erkennbar, dass die große Dehnung D um einen Faktor fünf dadurch gefördert wird, dass für die axiale Verschiebung der beiden unabhängig voneinander verschiebbaren Linsengruppen 33 und 36 zwischen der eintrittsseitigen ersten Linse 30 und der fest montierten sechsten Linse 37 viel Raum zur Verfügung steht (ca. 70% der Baulänge). Dabei kann die erste Linsengruppe 33 zwischen ihrer objektnächsten Stellung (Zoom-Stellung 5, entsprechend maximalem Radius des Beleuchtungsflecks) und ihrer bildnächsten Stellung (Zoom-Stellung 1, entsprechend minimalem Radius des Beleuchtungsflecks) um einen maximalen Verschiebeweg von ca. 500mm verschoben werden, was mehr als 1/3 bzw. fast genau der Hälfte der Gesamtbaulänge des Zoom-Objektives entspricht. Der maximale Verschiebeweg der zweiten verschiebbaren Linsengruppe 36 zwischen ihrer objektnächsten Stellung (Zoom-Stellung 4) und der bildnächsten Stellung (Zoom-Stellung 1) beträgt ca. 225mm bzw. mehr als 20% der Gesamtbaulänge. Zwischen den verschiebbaren Linsen befindet sich keine feststehende Linse. Damit kann sich die erste Linsengruppe in einer Zoomstellung an einem Ort befinden, der in einer anderen Zoomstellung von der zweiten Linsengruppe eingenommen wird. Es gibt insoweit keine Einschränkung der Verfahrwege. Darüber hinaus ist der minimale Abstand der beweglichen Linsengruppen mindestens so groß wie der minimale Bilddurchmesser, so dass Kollisionen durch "Überschwinger" bei großen Beschleunigungen ausgeschlossen sind. An Hand von Fig. 2 ist auch zu erkennen, dass zwischen den Verschiebekurven der verschiebbaren Linsengruppen 33 und 36 kein einfacher linearer Zusammenhang existiert und dass die beweglichen Unsengruppen auch bezogen auf die dargestellte lineare Bildgrößenvariation auf nicht-linearen Kurven (gestrichelt) verfahren werden. Bei der beschriebenen Ausführungsform sind zur Durchführung dieser Axialbewegungen unabhängig ansteuerbare Antriebe für die beiden Linsengruppen 33, 36 vorgesehen.

Bei der verschiebbaren Linsengruppe 33 und den feststehenden Linsen 37, 38 variiert die beleuchtete Fläche zwischen den einzelnen Zoomstellungen stark, wobei der beleuchtete Durchmesser vorzugsweise zwischen ca. 60% und ca. 100% des Linsendurchmessers liegt. Der achsnahe Teil kann für die Korrektion bei Zoomstellung mit kleinem Bildfeld verwendet werden, während die Randbereiche bei Zoomstellungen mit großem Bilddurchmesser genutzt werden. Zwar ist die energetische Belastung bei verschiedenen Zoomstellungen unterschiedlich, doch macht dies bei den vergleichsweise großen Linsen keine Probleme.

Eine weitere Besonderheit des Systems gemäß Fig. 2 liegt darin, dass es eine asphärische Fläche (Eintrittsfläche F6 der dritten Linse 32) enthält, die zudem über einen großen Verschiebungsbereich axial verschiebbar ist. Dadurch, dass Linsen vom Bereich nahe der Objektebene (Zoom-Stellung 5) bis relativ nahe zum Bereich der Bildebene geschoben werden können, gibt es optische Mittel, die abhängig von der Zoom-Stellung sind und sowohl zur Winkelkorrektion als auch zur Ortskorrektion verwendet werden können. Wenn man, wie bei dem Ausführungsbeispiel gemäß Fig. 2, mindestens eines der verschiebbaren Elemente noch mit mindestens einer asphärischen Fläche versieht, hat man die Zahl der Freiheitsgrade zusätzlich erhöht.

Das Zoom-System zeichnet sich außerdem durch eine außerordentlich günstige, "entspannte" Strahlführung aus. Dies ist unter anderem daraus ersichtlich, dass der maximale Inzidenzwinkel i der auf eine optische Fläche des Zoom-Systems auftreffenden Strahlung bei keiner Zoom-Stellung größer als ca. 44 Grad wird (sin i < 0,69). Als Inzidenzwinkel wird hier der Winkel zwischen der Einstrahlrichtung eines Lichtstrahles und der Flächennormalen einer optischen Fläche am Auftreffpunkt bezeichnet. Diese niedrigen Inzidenzwinkel sind günstig für die Vermeidung von Bildfehlern und ermöglichen es vor allem, die optischen Flächen der Linsen mit geeigneten Antireflexbeschichtungen wirksam zu entspiegeln, wodurch die Transmission des Gesamtsystems erhöht und die Erzeugung von Falschlicht vermindert werden kann. Die entspannte Strahlführung wird durch eine besondere Brechkraftverteilung begünstigt. Einer axial festen eingangsseitigen negativen Brechkraft folgt erst eine positive und dann eine negative verschiebbare Brechkraft. Ausgangsseitig ist feste positive Brechkraft vorgesehen.

Die Erfindung umfasst auch ein Verfahren, die Lichtverteilung in der Bildebene 8 zu beeinflussen, und zwar ohne Veränderung der Position der Linsen des Zoom-Systems. Es wurde herausgefunden, dass eine Kippung und/oder Dezentrierung der eingangsseitigen Lichtverteilung des Lasers dazu genutzt werden kann, um (unabhängig von der Zoom-Stellung) einen konstanten Bildversatz und einen konstanten Winkelkipp der Lichtverteilung in der Bildebene des Zoom-Systems einzustellen. Als Kippung wird hier eine Winkelverstellung der Laserstrahlrichtung relativ zur optischen Achse des Beleuchtungssystems bezeichnet. Eine Dezentrierung der eingangsseitigen Lichtverteilung bedeutet eine Verschiebung dieser Lichtverteilung senkrecht zur optischen Achse.

Durch Manipulation bzw. Einstellung der Konvergenz/Divergenz der in die Beleuchtungseinrichtung eintretenden Laserstrahlung kann alternativ oder zusätzlich die axiale Position (z-Position) der Bildebene in Abhängigkeit von der Zoomstellung verändert werden. Die hier vorgeschlagene z-Manipulation der Lage der Bildebene 8 durch Variation der Konvergenz/Divergenz des einfallenden Laserstrahls kann zur Justierung bzw. Einstellung der axialen Position der Bildebene 8 des Zoom-Systems genutzt werden. Die Divergenz/Konvergenz der in das Zoom-System einfallenden Laserstrahlung kann beispielsweise durch Einfügung und/oder Verlagerung optischer Elemente im Strahlengang vor dem Zoom-System erreicht werden, beispielsweise durch Einfügung und/oder Verschiebung von Linsen und /oder durch Manipulation der Strahldivergenz mittels des Strahlumformers 4. Dadurch kann erreicht werden, dass die Hauptstrahlen der Laserstrahlung nicht mehr im wesentlichen parallel, sondern im Winkel zueinander verlaufen, was einer Verlagerung der Lage einer quasi-punktförmigen Lichtquelle aus dem Unendlichen ins Endliche entspricht. Diese Einführung von Konvergenz/Divergenz ist von der Einführung einer Apertur durch ein DOE oder dergleichen zu unterschieden, bei der eine Apertur bzw. Winkelverteilung bei fest vorgegebener und lokal unveränderter Hauptstrahlrichtung eingeführt wird. Dieses Verfahren ist beispielsweise nützlich, um bei eingebautem Zoom ohne konstruktive Änderungen am Zoom-System die Lage der Bildebene 8 der verschiedenen Zoomstellungen aufeinander abzustimmen. Beispielsweise führt eine Variation der Hauptstrahlrichtungen des einfallenden Laserstrahles um 0,1 mrad abhängig von der Zoomstellung zu einer axialen Verlagerung der Bildebene 8 um ca. 10 mm (bei Zoomstellung 1) bis zu ca. 500 mm (bei Zoomstellung 5), was einer Variationsbreite zwischen ca. 1 % und 50% der Gesamtbaulänge des Zoom-Systems entspricht. Daher kann die Lage der Bildebene, die zu der Zoomstellung mit maximal großem Beleuchtungsfleck gehört, fast unabhängig von der Bildebenenlage des minimalen Lichtflecks verändert werden.

Das Verfahren kann unabhängig von der Art des Zoom-Systems auch bei anderen Beleuchtungseinrichtungen nützlich sein.

Die erste Linse 30 ist so gelagert, dass sie senkrecht zur optischen Achse 3 zweidimensional verschiebbar ist. Das Design des Zoom-Systems ist so ausgelegt, dass eine Dezentrierung der ersten Linse von der optischen Achse weg in erster Näherung ausschließlich auf den Versatz des Bildfeldes wirkt. Typische Dezentrierungen können im Bereich von Bruchteilen von Millimetern liegen. Diese Dezentrierung kann dazu verwendet werden, die Versetzung des Bildfeldes, welche beispielsweise durch Toleranzen der optischen Elemente und ihrer Halterungen auftritt, zu verkleinern oder vollständig zu kompensieren.

Die in Fig. 3 gezeigte zweite nicht zur beanspruchten Erfindung gehörende, Ausführungsform eines Zoom-Systems 7 hat im wesentlichen den gleichen Aufbau wie die beschriebene erste Ausführungsform in Fig. 2. Wesentlicher Unterschied ist hier, dass bei der zweiten Ausführungsform alle Linsenflächen sphärisch gekrümmt sind, was die Fertigung der Linsen erleichtert. Dieses Zoom-System wird im Beispielsfall in Kombination mit einem in der Objektebene 6 angebrachten diffraktiven optischem Element verwendet, dessen mittlere numerische Apertur 25mrad beträgt. Die Baulänge beträgt 1050mm. Die übrigen Parameter, insbesondere Linsenmaterial, Betriebswellenlänge, Dehnung, minimaler bzw. maximaler Radius der ausleuchtbaren Fläche, maximaler Verschiebeweg der ersten Linsengruppe und der zweiten Linsengruppe, Energiedichtvariation in der Bildebene, bildseitige Telezentrie etc., entsprechen dem ausführlich beschriebenem Ausführungsbeispiel in Fig. 2. Die Krümmungsradien r der Linsenflächen, die entsprechenden Dicken d sowie die halben maximalen Strahlendurchmesser hmax sind in Tabelle 4 gezeigt. In Tabelle 5 sind für fünf verschiedene Zoom-Stellungen (Zoom-Stellung 1 bis Zoom-Stellung 5, in Fig. 3 von oben nach unten) die axialen Dimensionen der variablen Lufträume hinter den Linsenflächen F3, F7 und F11 gezeigt.

**Tabelle 1**

| Fläche | Radius r (mm) | Dicke d (mm) | Halber Durchmesser hmax (mm) |
|---|---|---|---|
| F1 | 0.0 | 40.01 | 16.50 |
| F2 | -104.82 | 3.89 | 17.54 |
| F3 | -163.95 | 3.00 | 17.88 |
| F4 | 110.88 | 14.97 | 48.72 |
| F5 | 496.91 | 0.06 | 47.91 |
| F6 | 65.17 | 25.83 | 45.45 |
| F7 | 48.29 | 307.73 | 35.93 |
| F8 | 55.54 | 7.08 | 33.01 |
| F9 | 74. 80 | 71.24 | 32.00 |
| F10 | -8145.54 | 10.32 | 18.76 |
| F11 | 51.97 | 242.03 | 17.04 |
| F12 | -131.57 | 34.67 | 40.74 |
| F13 | -127.16 | 120.04 | 46.80 |
| F14 | 380.10 | 38.60 | 57.03 |
| F15 | 0.00 | 100.12 | 56.85 |

**Tabelle 2**

| Fläche | Konische Konstante k | C1 | C2 | C3 | C4 |
|---|---|---|---|---|---|
| | | | | | |
| F6 | 0.47416 | -2.12695 e-07 | -2.284472 e-010 | 1.328999 e-13 | -5.565044 e-17 |

**Tabelle 3**

| Fläche | Zoom-St. 1 | Zoom-St. 2 | Zoom-St. 3 | Zoom-St. 4 | Zoom-St. 5 |
|---|---|---|---|---|---|
| F3 | 500.89 | 306.20 | 171.60 | 69.83 | 3.00 |
| F7 | 42.01 | 46.25 | 140.00 | 238.88 | 307.73 |
| F11 | 10.86 | 200.30 | 241.15 | 244.05 | 242.03 |

**Tabelle 4**

| Fläche | Radius r (mm) | Dicke d (mm) | Halber Durchmesser hmax (mm) |
|---|---|---|---|
| F1 | 0.0 | 40.07 | 12.50 |
| F2 | -79.15 | 5.97 | 13.47 |
| F3 | -109.96 | 3.04 | 13.96 |
| F4 | 79.41 | 12.74 | 39.40 |
| F5 | 347.11 | 0.09 | 38.66 |
| F6 | 63.66 | 19.36 | 36.74 |
| F7 | 41.08 | 329.97 | 29.39 |
| F8 | 50.77 | 19.11 | 27.23 |
| F9 | 46.51 | 93.30 | 22.84 |
| F10 | 9068.70 | 11.63 | 14.84 |
| F11 | 81.50 | 220.34 | 14.86 |
| F12 | -134.14 | 31.52 | 38.03 |
| F13 | -124.17 | 120.00 | 43.13 |
| F 14 | 391.31 | 38.60 | 52.17 |
| F15 | 0.00 | 100.21 | 52.02 |

**Tabelle 5**

| Fläche | Zoom-St. 1 | Zoom-St. 2 | Zoom-St. 3 | Zoom-St. 4 | Zoom-St. 5 |
|---|---|---|---|---|---|
| F3 | 499.97 | 316.29 | 215.22 | 79.01 | 3.04 |
| F7 | 40.01 | 54.26 | 124.45 | 251.43 | 329.97 |
| F11 | 13.36 | 182.80 | 213.68 | 222.91 | 220.34 |

## Patentansprüche

1. Zoom-System für eine Beleuchtungseinrichtung, insbesondere eine Beleuchtungseinrichtung einer mikrolithographischen Projektionsbelichtungsanlage, das Zoom-System mit:
einer Vielzahl von Linsen, die entlang einer optischen Achse (3) angeordnet sind und eine Objektebene (6) und eine Bildebene (8) definieren,
wobei mindestens eine der Linsen (31, 32, 34, 35) eine verschiebbare Linse ist, die zur Variation der Größe einer in der Bildebene (8) ausgeleuchteten Fläche entlang der optischen Achse (3) verschiebbar ist, **dadurch gekennzeichnet,**
**dass** ein Verhältnis D zwischen einer maximalen Größe und einer minimalen Größe der in der Bildebene (8) ausgeleuchteten Fläche (Dehnungsfaktor) mehr als vier beträgt
und **dass** zwischen der Objektebene (6) und der Bildebene (8) mindestens eine optische Komponente (32) mit mindestens einer asphärischen Fläche (F6) angeordnet ist.

2. Zoom-System nach Anspruch 1, bei dem zwischen Objektebene (6) und Bildebene (8) mindestens eine verschiebbare optische Komponente (32) mit mindestens einer asphärischen Fläche (F6) angeordnet ist

3. Zoom-System nach Anspruch 1 oder 2, bei dem zwischen der Objektebene (6) und der Bildebene (8) mindestens eine optische Komponente (32) mit mindestens einer asphärischen Fläche (F6) angeordnet ist, die in der Nähe der Objektebene angeordnet oder anordenbar ist.

4. Zoom-System nach einem der vorhergehenden Ansprüche, bei dem das Verhältnis D größer oder gleich fünf ist.

5. Zoom-System nach einem der vorhergehenden Ansprüche, bei dem die Bildebene (8) eine Fourier-transformierte Ebene zur Objektebene (6) ist (Brennweiten-Zoom).

6. Zoom-System nach einem der vorhergehenden Ansprüche, wobei das Zoom-System (7) keine Zwischenbildebene aufweist.

7. Zoom-System nach einem der vorhergehenden Ansprüche, bei dem ein maximaler Verschiebeweg mindestens einer der verschiebbaren Linsen (31, 32) mehr als ca. 35% der Baulänge des Zoom-Systems (7) beträgt, wobei vorzugsweise mindestens eine derverschiebbaren Linsen einen maximalen Verschiebeweg hat, der mindestens ca. 45% der Baulänge des Zoom-Systems beträgt.

8. Zoom-System nach einem der vorhergehenden Ansprüche, bei dem mindestens ein optisches Element (30) in der Nähe der Objektebene (6) angeordnet ist, wobei vorzugsweise ein Abstand zwischen Objektebene (6) und dem optischen Element (30) weniger als 15%, insbesondere weniger als 5% der Baulänge des Zoom-Systems entspricht.

9. Zoom-System nach einem der vorhergehenden Ansprüche, bei dem ein Verschiebebereich für mindestens eine der verschiebbaren Linsen (31, 32) in einem Abstand von der Objektebene (6) endet, der weniger als 15%, insbesondere weniger als 5% der Baulänge des Zoom-Objektivs beträgt.

10. Zoom-System nach einem der vorhergehenden Ansprüche, bei dem ein Verschiebebereich für mindestens eine der verschiebbaren Linsen (34, 35) in einem Abstand von der Bildebene (8) endet, der weniger als 50%, insbesondere weniger als 35% der Baulänge des Zoom-Objektives beträgt.

11. Zoom-System nach einem der vorhergehenden Ansprüche, wobei das Zoom-System axial feststehende Linsen (30, 37, 38) und axial verschiebbare Linsen (31, 32, 34, 35) aufweist und die Anzahl der verschiebbaren Linsen gleich oder größer ist als die Anzahl der feststehenden Linsen.

12. Zoom-System nach einem der vorhergehenden Ansprüche, bei dem die verschiebbaren Linsen mindestens eine Linsengruppe (33, 36) mit zwei oder mehr gemeinsam verschiebbaren Linsen (31, 32, 34, 35) umfasst.

13. Zoom-System nach einem der vorhergehenden Ansprüche, **dadurch gekennzeichnet, dass** es maximal zwei verschiebbare Linsen oder Linsengruppen (33, 36) aufweist.

14. Zoom-System nach Anspruch 12 oder 13, bei dem jede verschiebbare Linsengruppe (33, 36) aus wenigstens zwei Einzellinsen (31, 32, 34, 35) besteht.

15. Zoom-System nach einem der vorhergehenden Ansprüche, bei dem sich zwischen verschiebbaren Linsen oder Linsengruppen keine feststehende Linse befindet.

16. Zoom-System nach einem der vorhergehenden Ansprüche, bei dem ein minimaler Abstand zwischen verschiebbaren Linsen oder Linsengruppen (33, 36) wenigstens so groß ist wie der minimale Bilddurchmesser.

17. Zoom-System nach einem der vorhergehenden Ansprüche, bei dem eine erste verschiebbare Linse oder Linsengruppe (33) und mindestens eine zweite verschiebbare Linse oder Linsengruppe (36) vorgesehen ist, die beim Wechsel zwischen verschiedenen Zoom-Stellungen auf unterschiedlichen Verschiebekurven verschiebbar sind.

18. Zoom-System nach einem der vorhergehenden Ansprüche, wobei das Zoom-System bildseitig telezentrisch ist und/oder bei dem das Zoom-System im wesentlichen vignettierungsfrei arbeitet und/oder bei dem Lichtbüschel in der Bildebene (8) bei jeder Zoomstellung eine Apertur von weniger als 0,055 haben.

19. Zoom-System nach einem der vorhergehenden Ansprüche, bei dem zwischen Objektebene (6) und Bildebene (8) weniger als 16 optisch wirksame Flächen vorgesehen sind, wobei das Zoom-System vorzugsweise nur 14 optisch wirksame Flächen hat.

20. Zoom-System nach einem der vorhergehenden Ansprüche, bei dem ein maximaler Inzidenzwinkel der auf eine optische Fläche auftreffenden Strahlung kleiner als 50°, insbesondere kleiner als 45° ist, wobei der maximale Inzidenzwinkel vorzugsweise ca. 44° beträgt.

21. Zoom-System nach einem der vorhergehenden Ansprüche, bei dem einer feststehenden negativen Brechkraft eine bewegliche positive Brechkraft, danach eine bewegliche negative Brechkraft und danach eine feststehende positive Brechkraft folgt.

22. Zoom-System nach einem der vorhergehenden Ansprüche, bei dem mindestens eine verschiebbare Linsengruppe und/oder mindestens eine feststehende Linsengruppe vorgesehen ist, deren beleuchtete Fläche stark variiert, insbesondere mit Durchmesser zwischen ca. 60% und 100% des Linsendurchmessers.

23. Zoom-System nach einem der vorhergehenden Ansprüche, bei dem mindestens eine der Linsen (30) quer zur optischen Achse (3) des Zoom-Systems dezentrierbar gelagert ist.

24. Zoom-System nach einem der vorhergehenden Ansprüche, **gekennzeichnet durch** dem Zoom-System zugeordnete Einstellmittel zur Einstellung der axialen Positionen der Bildebene (8) entlang der optischen Achse (3), wobei die Einstellmittel vorzugsweise mindestens eine Einrichtung zur Veränderung der Konvergenz/Divergenz der von einer Lichtquelle (2) kommenden Strahlung umfassen.

25. Beleuchtungseinrichtung (1) für eine mikrolithographische Projektionsbelichtungsanlage mit einem Zoom-System zur Variation des Kohärenzgrades der von der Beleuchtungseinrichtung bereitbestellbaren Beleuchtung, wobei das Zoom-System gemäß einem der Ansprüche 1 bis 24 aufgebaut ist.

26. Verfahren zur Herstellung von Halbleiterbauelementen und anderen feinstrukturierten Bauteilen mit folgenden Schritten:
Beleuchtung eines in einer Objektebene eines Projektionsobjektivs angeordneten Retikels (16) mit Hilfe einer Beleuchtungseinrichtung (1), die ein Zoom-System (7) umfasst, welches gemäß einem der Ansprüche 1 bis 24 aufgebaut ist;
Erzeugung eines Bildes des Retikels auf einem lichtempfindlichen Substrat;
wobei der Schritt der Beleuchtung des Retikels eine Änderung der Eigenschaften des auf das Retikel einfallenden Lichtstrahles durch Verschiebung mindestens einer Linse des Zoom-Systems entlang der optischen Achse des Zoom-Systems umfasst.

## Claims

1. Zoom system for an illuminator, in particular an illuminator of a microlithographic projection exposure machine, the zoom system having:
a multiplicity of lenses which are arranged along an optical axis (3) and define an object plane (6) and an image plane (8),
at least one of the lenses (31, 32, 34, 35) being a displaceable lens which can be displaced along the optical axis (3) in order to vary the size of a surface area illuminated in the image plane (8),
**characterized in that** the ratio D between a maximum size and a minimum size of the surface area illuminated in the image plane (8) (expansion factor) is more than four,
and **in that** at least one optical component (32) having at least one aspheric surface (F6) is arranged between the object plane (6) and the image plane (8).

2. Zoom system according to Claim 1, wherein at least one displaceable optical component (32) having at least one aspheric surface (F6) is arranged between the object plane (6) and image plane (8).

3. Zoom system according to Claim 1 or 2, wherein at least one optical component (32) having at least one aspheric surface (F6) which is or can be arranged in the vicinity of the object plane is arranged between the object plane (6) and the image plane (8).

4. Zoom system according to one of the preceding claims, wherein the ratio D is greater than or equal to five.

5. Zoom system according to one of the preceding claims, wherein the image plane (8) is a Fourier-transformed plane relative to the object plane (6) (focal length zoom).

6. Zoom system according to one of the preceding claims, wherein the zoom system (7) has no intermediate image plane.

7. Zoom system according to one of the preceding claims, wherein a maximum displacement path of at least one of the displaceable lenses (31, 32) is more than approximately 35% of the overall length of the zoom system (7), preferably at least one of the displaceable lenses having a maximum displacement path which is at least approximately 45% of the overall length of the zoom system.

8. Zoom system according to one of the preceding claims, wherein at least one optical element (30) is arranged in the vicinity of the object plane (6), a spacing between the object plane (6) and the optical element (30) preferably corresponding to less than 15%, in particular less than 5% of the overall length of the zoom system.

9. Zoom system according to one of the preceding claims, wherein a displacement range for at least one of the displaceable lenses (31, 32) ends at a distance from the object plane (6) which is less than 15%, in particular less than 5% of the overall length of the zoom objective.

10. Zoom system according to one of the preceding claims, wherein a displacement range for at least one of the displaceable lenses (34, 35) ends at a distance from the image plane (8) which is less than 50%, in particular less than 35% of the overall length of the zoom objective.

11. Zoom system according to one of the preceding claims, wherein the zoom system has axially stationary lenses (30, 37, 38) and axially displaceable lenses (31, 32, 34, 35), and the number of the displaceable lenses is equal to or greater than the number of the stationary lenses.

12. Zoom system according to one of the preceding claims, wherein the displaceable lenses comprise at least one lens group (33, 36) having two or more commonly displaceable lenses (31, 32, 34, 35).

13. Zoom system according to one of the preceding claims, **characterized in that** it has a maximum of two displaceable lenses or lens groups (33, 36).

14. Zoom system according to Claim 12 or 13, wherein each displaceable lens group (33, 36) consists of at least two single lenses (31, 32, 34, 35).

15. Zoom system according to one of the preceding claims, wherein no stationary lens is located between displaceable lenses or lens groups.

16. Zoom system according to one of the preceding claims, wherein a minimum spacing between displaceable lenses or lens groups (33, 36) is at least as large as the minimum image diameter.

17. Zoom system according to one of the preceding claims, wherein a first displaceable lens or lens group (33) and at least one second displaceable lens or lens group (36) are provided which can be displaced on different displacement curves when changing between various zoom settings.

18. Zoom system according to one of the preceding claims, wherein the zoom system is telecentric on the image side and/or wherein the zoom system operates substantially without vignetting and/or wherein light bundles in the image plane (8) have an aperture of less than 0.055 for each zoom setting.

19. Zoom system according to one of the preceding claims, wherein less than 16 optically effective surfaces are provided between the object plane (6) and image plane (8), the zoom system preferably having only 14 optically effective surfaces.

20. Zoom system according to one of the preceding claims, wherein a maximum incidence angle of the radiation impinging on an optical surface is smaller than 50°, in particular smaller than 45°, the maximum incidence angle preferably being approximately 44°.

21. Zoom system according to one of the preceding claims, wherein a fixed negative refractive power is followed by a moveable positive refractive power, thereafter by a moveable negative refractive power, and thereafter by a fixed positive refractive power.

22. Zoom system according to one of the preceding claims, wherein at least one displaceable lens group and/or at least one stationary lens group is provided whose illuminated surface area varies strongly, in particular having a diameter of between approximately 60% and 100% of the lens diameter.

23. Zoom system according to one of the preceding claims, wherein at least one of the lenses (30) is supported in a fashion capable of being decentred transverse to the optical axis (3) of the zoom system.

24. Zoom system according to one of the preceding claims, **characterized by** setting means, assigned to the zoom system, for setting the axial positions of the image plane (8) along the optical axis (3), the setting means preferably comprising at least one device for varying the convergence/divergence of the radiation coming from a light source (2).

25. Illuminator (1) for a microlithographic projection exposure machine, having a zoom system for varying the degree of coherence of the illumination provided by the illuminator, the zoom system being constructed in accordance with one of Claims 1 to 24.

26. Method for producing semiconductor components and other finely structured assemblies, having the following steps:
illuminating a reticle (16), arranged in an object plane of a projection objective, with the aid of an illuminator (1) which comprises a zoom system (7) which is constructed in accordance with one of Claims 1 to 24; and
producing an image of the reticle on a photosensitive substrate;
the step of illuminating the reticle comprising a change in the properties of the light beam incident on the reticle by displacement of at least one lens of the zoom system along the optical axis of the zoom system.

## Revendications

1. Système de zoom pour un dispositif d'éclairage, notamment un dispositif d'éclairage d'un équipement d'éclairage de projection microlithographique, le système de zoom comprenant :
une pluralité de lentilles qui sont disposées le long d'un axe optique (3) et définissent un plan d'objet (6) et un plan d'image (8),
au moins l'une des lentilles (31, 32, 34, 35) étant une lentille mobile qui peut être déplacée le long de l'axe optique (3) pour faire varier la taille d'une surface éclairée dans le plan d'image (8),
**caractérisé en ce**
**qu'**un rapport D entre une grandeur maximale et une grandeur minimale de la surface éclairée dans le plan d'image (8) (facteur d'extension) est supérieur à quatre
et **qu'**entre le plan d'objet (6) et le plan d'image (8) est disposé au moins un composant optique (32) comprenant au moins une surface asphérique (F6).

2. Système de zoom selon la revendication 1, avec lequel, entre le plan d'objet (6) et le plan d'image (8), est disposé au moins un composant optique (32) mobile comprenant au moins une surface asphérique (F6).

3. Système de zoom selon la revendication 1 ou 2, avec lequel, entre le plan d'objet (6) et le plan d'image (8), est disposé au moins un composant optique (32) mobile comprenant au moins une surface asphérique (F6) qui est disposée ou peut être disposée à proximité du plan d'objet.

4. Système de zoom selon l'une des revendications précédentes, avec lequel le rapport D est égal ou supérieur à cinq.

5. Système de zoom selon l'une des revendications précédentes, le plan d'image (8) est un plan ayant subit une transformation de Fourier par rapport au plan d'objet (6) (zoom à réglage du foyer).

6. Système de zoom selon l'une des revendications précédentes, le système de zoom (7) ne présentant pas de plan d'image intermédiaire.

7. Système de zoom selon l'une des revendications précédentes, avec lequel une course de déplacement maximale au moins d'une des lentilles mobiles (31, 32) est supérieure à environ 35 % de la longueur hors tout du système de zoom (7), au moins l'une des lentilles mobiles possédant de préférence une course de déplacement maximale qui est au moins égale à environ 45 % de la longueur hors tout du système de zoom.

8. Système de zoom selon l'une des revendications précédentes, avec lequel au moins un élément optique (30) est disposé à proximité du plan d'objet (6), un écart entre le plan d'objet (6) et l'élément optique (30) correspondant de préférence à moins de 15 %, notamment à moins de 5 % de la longueur hors tout du système de zoom.

9. Système de zoom selon l'une des revendications précédentes, avec lequel une plage de déplacement pour au moins l'une des lentilles mobiles (31, 32) se termine à une distance du plan d'objet (6) qui est inférieure à 15 %, notamment inférieure à 5 % de la longueur hors tout de l'objectif de zoom.

10. Système de zoom selon l'une des revendications précédentes, avec lequel une plage de déplacement pour au moins l'une des lentilles mobiles (34, 35) se termine à une distance du plan d'image (8) qui est inférieure à 50 %, notamment inférieure à 35 % de la longueur hors tout de l'objectif de zoom.

11. Système de zoom selon l'une des revendications précédentes, le système de zoom présentant des lentilles fixes dans le sens axial (30, 37, 38) et des lentilles mobiles dans le sens axial (31, 32, 34, 35) et le nombre de lentilles mobiles est égal ou supérieur au nombre de lentilles fixes.

12. Système de zoom selon l'une des revendications précédentes, avec lequel les lentilles mobiles comprennent au moins un groupe de lentilles (33, 36) avec deux lentilles ou plus (31, 32, 34, 35) pouvant être déplacées ensemble.

13. Système de zoom selon l'une des revendications précédentes, **caractérisé en ce qu'**il présente un maximum de deux lentilles ou groupes de lentilles mobiles (33, 36).

14. Système de zoom selon la revendication 12 ou 13, avec lequel chaque groupe de lentilles mobile (33, 36) se compose d'au moins deux lentilles individuelles (31, 32, 34, 35).

15. Système de zoom selon l'une des revendications précédentes, avec lequel aucune lentille fixe ne se trouve entre les lentilles ou les groupes de lentilles mobiles.

16. Système de zoom selon l'une des revendications précédentes, avec lequel un écart minimum entre les lentilles ou les groupes de lentilles mobiles (33, 36) a une taille au moins égale au diamètre minimum de l'image.

17. Système de zoom selon l'une des revendications précédentes, avec lequel une première lentille ou un premier groupe de lentilles mobile (33) et au moins une deuxième lentille ou un deuxième groupe de lentilles mobile (36) sont prévus, lesquels peuvent être déplacés sur différentes courbes de déplacement lors du changement entre différentes positions de zoom.

18. Système de zoom selon l'une des revendications précédentes, le système de zoom étant télécentrique du côté image et/ou avec lequel le système de zoom fonctionne pour l'essentiel sans effet de vignettage et/ou avec lequel les aigrettes lumineuses dans le plan d'image (8) ont une ouverture inférieure à 0,055 dans chaque position de zoom.

19. Système de zoom selon l'une des revendications précédentes, avec lequel moins de 16 surfaces optiquement effectives sont prévues entre le plan d'objet (6) et le plan d'image (8), le système de zoom ne possédant de préférence que 14 surfaces optiquement effectives.

20. Système de zoom selon l'une des revendications précédentes, avec lequel un angle d'incidence maximum du rayon qui vient heurter une surface optique est inférieur à 50°, notamment inférieur à 45°, l'angle d'incidence maximum étant de préférence égal à environ 44°.

21. Système de zoom selon l'une des revendications précédentes, avec lequel une réfringence négative fixe suit une réfringence positive mobile, ensuite une réfringence négative mobile et ensuite une réfringence positive fixe.

22. Système de zoom selon l'une des revendications précédentes, avec lequel il est prévu au moins un groupe de lentilles mobile et/ou au moins un groupe de lentilles fixe dont la surface éclairée varie fortement, notamment avec un diamètre entre environ 60 % et 100 % du diamètre de la lentille.

23. Système de zoom selon l'une des revendications précédentes, avec lequel au moins l'une des lentilles (30) est logée de matière à pouvoir être décentrée transversalement par rapport à l'axe optique (3) du système de zoom.

24. Système de zoom selon l'une des revendications précédentes, **caractérisé par** des moyens de réglage associés au système de zoom pour régler les positions axiales du plan d'image (8) le long de l'axe optique (3), les moyens de réglage comprenant de préférence au moins un dispositif pour modifier la convergence/divergence du rayonnement en provenance d'une source de lumière (2).

25. Dispositif d'éclairage (1) pour un équipement d'éclairage de projection microlithographique comprenant un système de zoom destiné à faire varier le degré de cohérence de l'éclairage pouvant être fourni par le dispositif d'éclairage, le système de zoom étant construit conformément à l'une des revendications 1 à 24.

26. Procédé de fabrication de composants semiconducteurs et d'autres composants à structure précise comprenant les étapes suivantes :
éclairage d'un réticule (16) disposé dans un plan d'objet d'un objectif de projection à l'aide d'un dispositif d'éclairage (1) qui comprend un système de zoom (7) qui est construit conformément à l'une des revendications 1 à 24 ;
production d'une image du réticule sur un substrat photosensible ;
l'étape d'éclairage du réticule comprenant une modification des propriétés du rayon lumineux incident sur le réticule en déplaçant au moins une lentille du système de zoom le long de l'axe optique du système de zoom.
